# EUROPEAN PATENT APPLICATION

(11) **EP 2 541 591 A2**
(43) Date of publication of application: **02.01.2013**
(21) Application number: 12173542.7
(22) Date of filing: 26.06.2012
(51) Int. Cl.: H01L 21/67

(54) **Gate valve and substrate processing system using same**

(30) Priority: 28.06.2011 JP 2011143129
(71) Applicant: TOKYO ELECTRON LIMITED, Minato-ku Tokyo 107-6325 (JP)
(72) Inventor: Tateshita, Koichi, Yamanashi, 407-8511 (JP)
(74) Representative: HOFFMANN EITLE

(57) **Abstract**

A gate valve includes a plurality of openings through which objects to be processed are loaded and unloaded; a valve body to be pressed toward the openings; a pressed portion provided to the valve body; a main slider slidable in parallel with a surface where the openings are formed; and a cam provided to the main slider and having a protrusion and an inclined portion inclined from the protrusion in a sloped shape, for pressing the pressed portion of the valve body in a state where the valve body faces the openings. The valve body has one or more slit-shaped openings serving as opening portions for opening the openings, and portions adjacent to the slit-shaped openings serving as blocking portions for blocking the openings.

## Description

### Field of the Invention

The present invention relates to a gate valve and a substrate processing system using same.

### Background of the Invention

In a manufacturing process of a flat panel display (FPD) represented by a liquid crystal display (LCD) or a solar cell, a predetermined treatment such as etching, film formation or the like is performed on a large-size glass substrate. As for a substrate processing system for performing such treatment, there is known a multi chamber type substrate processing system having a plurality of processing chambers (e.g., Japanese Patent Application Publication No. H5-196150 (JP5-196150A) and Japanese Patent Application Publication No. 2011-54928 (JP2011-54928A)).

Such multi chamber type substrate processing system includes a common transfer chamber where a transfer device for transferring a substrate (an object to be processed) is provided. Further, a processing chamber and a load-lock chamber where an unprocessed substrate is exchanged with a processed substrate from the common transfer chamber under the atmospheric environment are provided around the common transfer chamber. The common transfer chamber, the processing chamber and the load-lock chamber are vacuum devices, and each of the insides thereof is exhausted to a predetermined depressurized state by operating a gas exhaust unit.

The vacuum device has an airtight vessel main body, and an opening for loading and unloading an object to be processed is formed at the vessel main body. The opening is opened and closed by using a gate valve. When the opening is closed by the gate valve, the vessel main body is airtightly sealed. Accordingly, a pressure in the vessel main body can be decreased to a predetermined processing pressure or switched between an atmospheric state and a depressurized state.

As for an example of the gate valve, there are known one using a link mechanism described in JP5-196150A and one using a cam mechanism described in JP2011-54928A.

As the trend toward scaling up of an object to be processed or batch type processing for simultaneously processing a plurality of objects to be processed advances, a size of an opening that is formed at the vessel main body to load and unload an object to be processed tends to be increased. Further, in the batch type processing, it is considered to increase the number of objects to be processed that can be processed simultaneously in order to suppress decrease of a throughput or to maintain/improve a throughput.

However, if the number of objects to be processed simultaneously is increased, the size of the opening is increased in a height direction, and an elevation distance of a valve body is also increased, thereby making it difficult to install a substrate processing system in a manufacturing factory.

### Summary of the Invention

In view of the above, the present invention provides a gate valve that can reduce an elevation distance of a valve body even when the number of objects to be processed simultaneously is increased, and a substrate processing system using the same.

In accordance with one aspect of the present invention, there is provided a gate valve including: a plurality of openings through which objects to be processed are loaded and unloaded; a valve body to be pressed toward the openings; a pressed portion provided to the valve body; a main slider slidable in parallel with a surface where the openings are formed; and a cam, provided to the main slider and having a protrusion and an inclined portion inclined from the protrusion in a sloped shape, for pressing the pressed portion of the valve body in a state where the valve body faces the openings, wherein the valve body has one or more slit-shaped openings serving as opening portions for opening the openings, and portions adjacent to the slit-shaped openings serving as blocking portions for blocking the openings.

In accordance with another aspect of the present invention, there is provided a substrate processing system including: a processing chamber having an opening through which an object to be processed is loaded and unloaded, the processing chamber serving to accommodate the object in a vacuum state and process the object; a load-lock chamber having an opening through which the object is loaded and unloaded, the load-lock chamber serving to accommodate the object in an atmospheric state as well as in a vacuum state and exchange an unprocessed object with a processed object; and a transfer chamber having an opening through which the object is loaded and unloaded, the transfer chamber serving to accommodate the object in a vacuum state and transfer the object between the load-lock chamber and the processing chamber, wherein the gate valve described in claim 1 is used as a gate valve for opening and closing the opening of at least one of the processing chamber, the load-lock chamber and the transfer chamber, through which the object is loaded and unloaded.

In accordance with the present invention, it is possible to provide a gate valve that can reduce an elevation distance of a valve body even when the number of objects to be processed simultaneously is increased, and a substrate processing system using the same.

### Brief Description of the Drawings

The objects and features of the present invention will become apparent from the following description of embodiments, given in conjunction with the accompanying drawings, in which:
Fig. 1 is a top view schematically showing an example of a substrate processing system using a gate valve in accordance with an embodiment of the present invention;
Figs. 2A to 2C are front views of the gate valve seen from an inside of a gate valve chamber in accordance with the embodiment of the present invention;
Figs. 3A and 3B show a comparative example;
Fig. 4 shows another comparative example;
Fig. 5 shows an advantage of the gate valve in accordance with the embodiment of the present invention;
Figs. 6A to 6C are partial side cross sectional views showing an operation example of the gate valve in accordance with the embodiment of the present invention;
Fig. 7 is a partial front cross sectional view showing a specific example of the gate valve in accordance with the embodiment of the present invention;
Fig. 8 is a horizontal cross sectional view taken along line 8-8 in Fig. 7;
Figs. 9A to 9C are cross sectional views taken along line 9-9 in Fig. 7;
Figs. 10A and 10B are vertical cross sectional views taken along line 10-10 in Fig. 7; and
Figs. 11A and 11B are vertical cross sectional views taken along line 11-11 in Fig. 7.

### Detailed Description of the Embodiments

Embodiments of the present invention will be described with reference to the accompanying drawings which form a part hereof. Throughout the drawings, like reference numerals refer to like parts.

In the present embodiment, a substrate processing apparatus for performing a predetermined treatment, e.g., etching, film formation or the like, on an object to be processed, e.g., a glass substrate used for fabrication of a FPD or a solar cell, will be described.

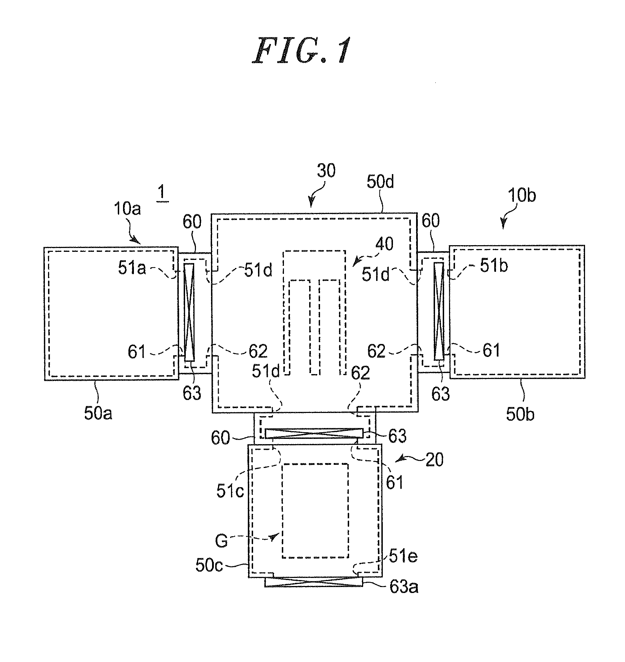

Fig. 1 is a top view schematically showing an example of a substrate processing system using a gate valve in accordance with the embodiment of the present invention.

As shown in Fig. 1, a substrate processing system 1 in accordance with the embodiment of the present invention includes: a plurality of processing chambers, i.e., processing chambers 10a and 10b in the present embodiment, for processing substrates G; a load-lock chamber 20 for exchanging an unprocessed substrate G and a processed substrate G; a common transfer chamber 30 for transferring a substrate G between the load-lock chamber 20 and the processing chamber 10a or 10b and between the processing chambers 10a and 10b; and a transfer unit 40, provided at the common transfer chamber 30, for transferring a substrate G. Although it is not particularly illustrated, the transfer unit 40 of the present embodiment supports a plurality of substrates G at multiple stages and transfers the substrates G together.

In the present embodiment, the processing chambers 10a and 10b, the load-lock chamber 20, and the common transfer chamber 30 are vacuum devices, and have airtight vessel main bodies 50a, 50b, 50c and 50d, respectively, each being capable of accommodating substrates G under a predetermined depressurized state. The vessel main bodies 50a to 50d are provided with openings 51a to 51d for loading and unloading substrates G. An opening 51e for loading and unloading a substrate G between the load-lock chamber 20 and the outside of the substrate processing system 1 is further provided at the vessel main body 50c of the load-lock chamber 20. The opening 51e is used for loading an unprocessed substrate G into the substrate processing system 1 and unloading a processed substrate G from the substrate processing system 1.

The common transfer chamber 30 is connected to the processing chambers 10a and 10b and the load-lock chamber 20 via gate valve chambers 60 accommodating therein gate valves. In the present embodiment, three gate valve chambers 60 are provided. Each of the gate valve chambers 60 forms a vacuum device having an inside that can be maintained in a predetermined depressurized state as in the vessel main bodies 50a to 50d.

Provided at the gate valve chambers 60 are openings 61 communicating with the openings 51a to 51c formed at the vessel main bodies 50a to 50c of the processing chambers 10a and 10b and the load-lock chamber 20 and openings 62 communicating with the openings 51d formed at the vessel main body 50d of the common transfer chamber 30. Substrates G are loaded and unloaded among the common transfer chamber 30, the processing chambers 10a and 10b and the load-lock chamber 20 via the openings 61 and 62.

The gate valve chamber 60 accommodates therein a valve body 63 of a gate valve. The valve body 63 of the gate valve is mainly formed by a unit for airtightly opening and closing an opening formed at one side of the gate valve chamber 60. In the present embodiment, the valve bodies 63 open and close the respective openings 61 (between the openings 61 and 62) for the processing chambers 10a and 10b and the load-lock chamber 20. The valve bodies 63 are pressed to the respective openings 61 and brought into airtight contact with the peripheries of the openings 61. Accordingly, the openings 51a to 51c are blocked, and the vessel main bodies 50a to 50c of the processing chambers 10a and 10b and the load-lock chamber 20 are airtightly sealed. The atmospheric side opening 51e of the load-lock chamber 20 is opened and closed by a valve 63a for allowing or blocking communication with an external environment in an atmospheric state.

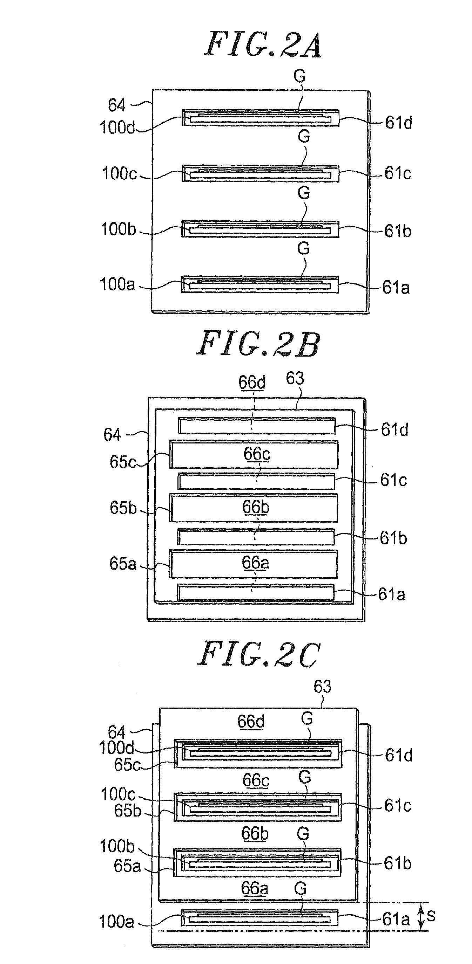

Figs. 2A to 2C are front views of a gate valve in accordance with the embodiment of the present invention which are seen from the inside of the gate valve chamber 60.

Fig. 2A shows an example of the openings 61 opened and closed by the valve body 63.

As shown in Fig. 2A, in the present embodiment, a plurality of openings 61 opened and closed by the valve body 63 to load and unload substrates is provided at sidewalls of the gate valve chambers 60 or at an attachable/detachable opening plate 64 forming the sidewalls of the gate valve chambers 60. In the present embodiment, four openings 61a to 61d are formed at the opening plate 64. Fig. 2A illustrates a plurality of substrate processing units (or substrate mounting units of the load-lock chamber 20) 100a to 100d provided in front of the openings 61a to 61d in the processing chambers 10a and 10b. The substrate processing units 100a to 100d mount thereon substrates G. In other words, the openings 61a to 61d are provided so as to correspond to the substrate processing units (or the substrate mounting units of the load-lock chamber 20) 100a to 100d, respectively.

Fig. 2B shows a state in which the openings 61a to 61d are closed by the valve body 63. Fig. 2C shows a state in which the openings 61a to 61d are opened by the valve body 63.

As shown in Figs. 2B and 2C, in the present embodiment, a plurality of slit-shaped openings 65 is provided at the valve body 63. In the present embodiment, three slit-shaped openings 65a to 65c are provided at the valve body 63. Four portions of the valve body 63 which are adjacent to the three slit-shaped openings 65a to 65c in a height direction (vertical direction) serve as blocking portions for blocking the four openings 61a to 61d (Fig. 2B). The three slit-shaped openings 65a to 65c serve as opening portions for opening the openings 61b to 61d among the four openings 61a to 61d. The lowermost opening 61a is opened by an elevation operation of the valve body 63. For example, the lowermost opening 61a is opened by sliding the valve body 63 upwardly and misaligning the opening 61a from the portion 66a (Fig. 2C). The number of the slit-shaped openings 65 may be the same as that of the openings 61. However, when the lowermost opening 61a is opened and closed by the elevation operation of the valve body 63 as in the present embodiment, the number of the slit-shaped openings 65a to 65c may be smaller than that of the openings 61a to 61d by one. This leads to reduction of a size and a weight of the valve body 63 and further leads to reduction of a size and a weight of the gate valve chamber 60. This is because when the valve body 63 is lowered to block the openings, it is unnecessary to provide a relief having an opening corresponding to the opening 61a of the valve body 63 at a lower portion of the gate valve chamber 60.

If one of the openings 61 is opened and closed by the elevation operation of the valve body 63 on the assumption that the number of the openings 61 is two, the number of the slit-shaped opening 65 is one.

In the gate valve in accordance with the embodiment of the present invention, a plurality of openings 61 (61a to 61d) for loading and unloading substrates G is provided at the sidewalls of the gate valve chamber 60 or at the opening plates 64, and one or more slit-shaped openings 65 (65a to 65c) are provided at the valve body 63 for opening and closing the openings 61a to 61d in accordance with the number of the openings 61. Further, four portions adjacent to the slit-shaped openings 65a to 65c in the height direction serve as blocking portions 66a to 66d for blocking the openings 61a to 61d, and the slit-shaped openings 65a to 65c serve as opening portions for opening the openings 61b to 61d among the openings 61a to 61d.

With the above configuration, even when the number of substrates G processed simultaneously is increased as shown in Fig. 2C, the elevation distance S of the valve body 63 in the case of opening the openings 61a to 61d can be reduced.

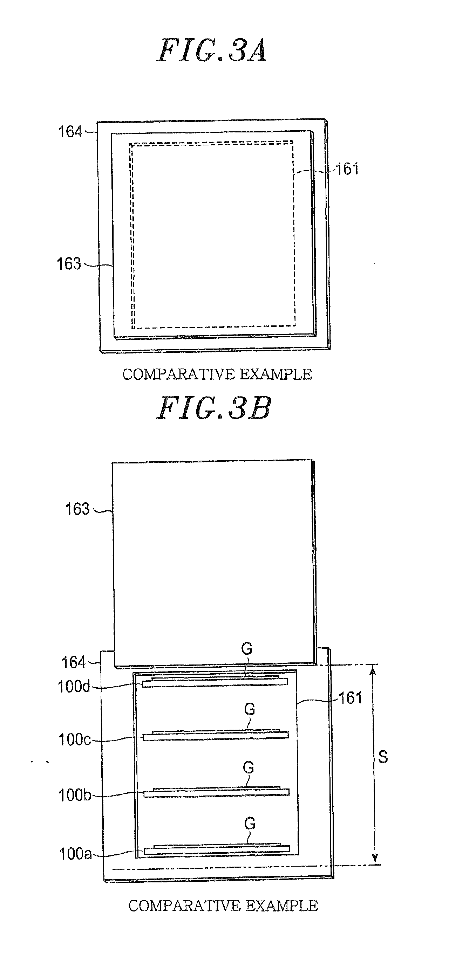

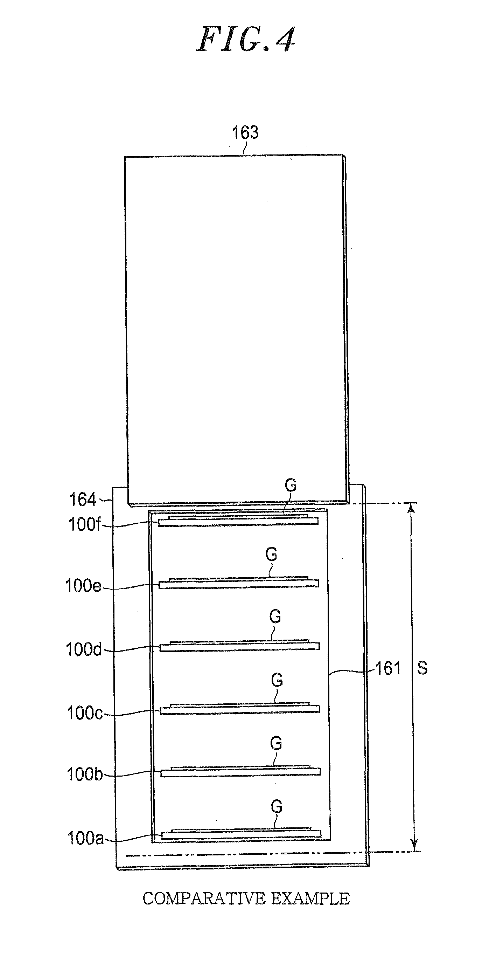

Figs. 3A, 3B, and 4 show comparative examples.

In the comparative examples as well as the above-described embodiment, four substrate processing units 100a to 100d are laminated in the height direction. Further, a single opening 161 is formed at an opening plate 164 and opened and closed by a single valve body 163.

As shown in Figs. 3A and 3B, when the single opening 161 is opened and closed by the single valve body 163, the valve body 163 needs to be elevated until the opening 161 is completely opened or until the opening 161 is completely closed. Therefore, the elevation distance S of the valve body 163 is increased compared to the elevation distance S of the valve body 63 in accordance with the above-described embodiment.

When the number of the laminated processing units 100 is increased as in the case of providing processing units 100a to 100f as shown in Fig. 4, the vertical size of the single opening 161 is increased in accordance with the number of the laminated processing units 100. Therefore, the elevation distance s of the valve body 163 is gradually increased as the vertical size of the opening 161 is increased.

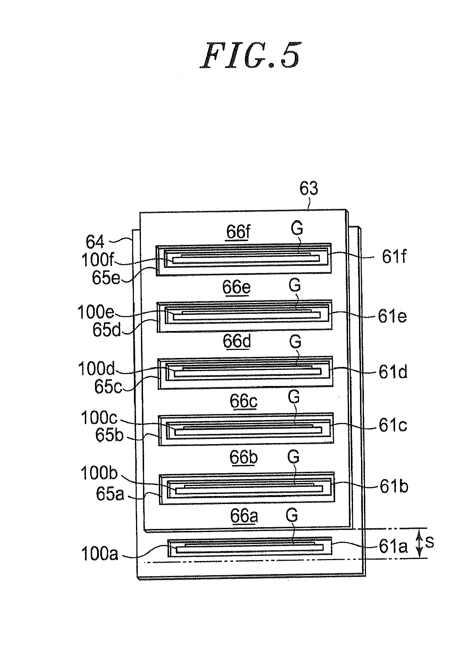

In accordance with the present embodiment, the elevation distance S of the valve body 63 is not changed even when the number of the processing units 100 is increased as in the case of providing the processing units 100a to 100f as shown in Fig. 5. This is because the elevation distance S of the present embodiment depends on the vertical size of the openings 61a to 61f corresponding to the processing units 100 without depending on the number of the laminated processing units 100.

Besides, in accordance with the present embodiment, since the elevation distance S is short, the period of time required to open and close the valve body 63 can be reduced, and a throughput can be improved.

Further, since the elevation distance S is short, the opening/closing speed of the valve body 63 can be reduced. If the opening/closing speed is reduced, it is unnecessary to provide a stopper below a main slider 70 which is required for a high-speed opening/closing operation. Furthermore, generation of dust particles can be suppressed.

Hereinafter, an operation example of a gate valve in accordance with the embodiment of the present invention will be described.

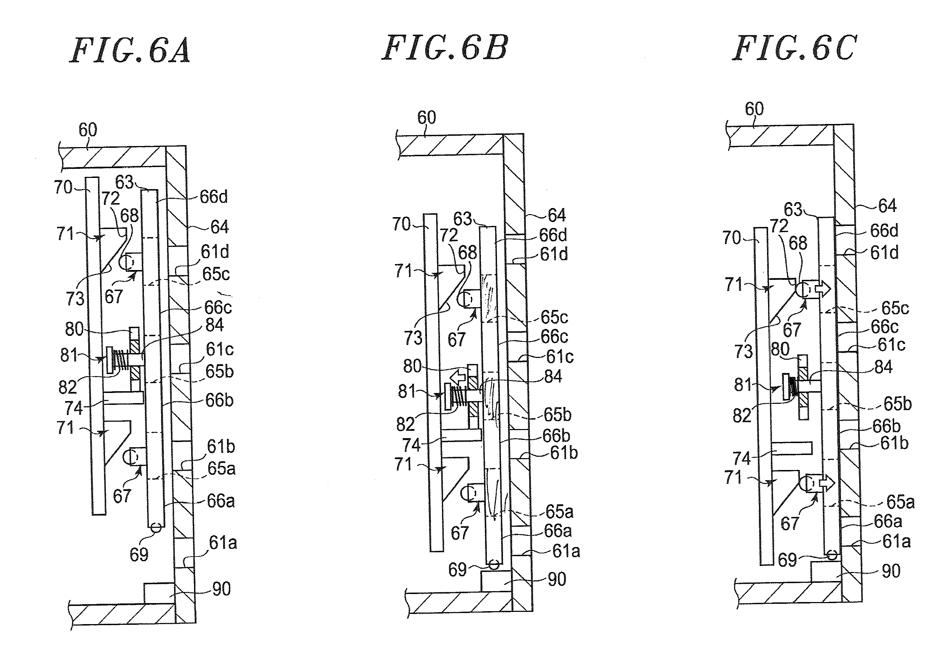

Figs. 6A to 6C are partial side cross sectional views showing an operation example of the gate valve in accordance with the embodiment of the preset invention. Fig. 6A shows a state in which the openings 61a to 61d are opened; Fig. 6B shows an intermediate state in which the openings 61a to 61d are being switched from an opening state to a blocking state and vice versa; and Fig. 6C shows a state in which the openings 61a to 61d are blocked.

As shown in Figs. 6A to 6C, the gate valve in accordance with the present embodiment includes: a main slider 70 sliding in parallel with a surface where the openings 61a to 61d are formed, e.g., in an elevation direction; and a sub-slider 80, provided between the sliding valve body 63 and the main slider 70 to hold the valve body 63, sliding in parallel with the surface where the openings 61a to 61d are formed , e.g., in an elevation direction, as in the main slider 70.

The main slider 70 is provided with a pressing unit 71 that presses the valve body 63 toward the openings 61a to 61d in a state where the valve body 63 directly faces the openings 61a to 61d. The valve body 63 is provided with a pressed portion 67 pressed with the pressing unit 71. The pressing unit 71 is configured as, e.g., a cam having a protrusion 72 and an inclined portion 73 inclined in a slope shape from the protrusion 72. The pressed portion 67 is configured as, e.g., a protrusion having a roller 68 that comes into contact with the cam (the pressing unit 71). The roller 68 rolls on the surfaces of the protrusion 72 and the inclined portion 73 by the sliding of the pressing unit 71, i.e., the vertical movement of the pressing unit 71 in the present embodiment.

### (In the case of blocking the openings 61a to 61d)

In the case of blocking the openings 61a to 61d by using the valve body 63, the positions of the blocking portions 66a to 66d are misaligned so as to directly face the openings 61a to 61d (Fig. 6B).

In the present embodiment, the main slider 70 has a hook portion 74 to which the sub-slider 80 is hooked. Further, in the present embodiment, a valve body stopper 90 for stopping the sliding of the valve body 63 is provided on the bottom surface of the gate valve chamber 60.

Until the sliding of the valve body 63 is stopped by the valve body stopper 90, the valve body 63 held by the sub-slider 80 is lowered by the sliding of the main slider 70, i.e., the downward movement of the main slider 70 in the present embodiment. When the downward movement of the valve body 63 is stopped by the valve body stopper 90, the sub-slider 80 is separated from the hook portion 74. The downward movement of the main slider 70 is continued even after the sub-slider 80 is separated from the hook portion 74. Then, the roller 68 of the pressed portion 67 is brought into contact with the inclined portion 73 of the pressing unit 71 and starts to roll along the inclined portion 73 toward the vertex of the protrusion 72.

Provided between the valve body stopper 90 and the valve body 63 is a roller 69 for reciprocally moving the valve body 63 in a direction that allows the valve body 63 to directly face a surface where the openings 61a to 61d are formed. In the present embodiment, the roller 69 is provided at the lower portion of the valve body 63. The roller 69 rolls on the horizontal top surface of the valve body stopper 90 when the roller 68 starts to roll toward the vertex of the protrusion, thereby moving the valve body 63 toward the openings 61a to 61d. As a consequence, the valve body 63 is pressed toward the surface where the openings 61a to 61d are formed by the cam of the pressing unit 71 and, then, the openings 61a to 61d are blocked by the blocking portions 66a to 66d (Fig. 6C).

### (In the case of opening the openings 61a to 61d)

In the case of opening the openings 61a to 61d by using the valve body 63, the pressing achieved with the cam of the pressing unit 71 is released and the positions of the slit-shaped openings 65a to 65c of the valve body 63 are moved so as to directly face the openings 61b to 61d. In the present embodiment, the number of the slit-shaped openings 65a to 65c is smaller than that of the openings 61a to 61d by one. Thus, the valve body 63 is moved from the position directly facing the opening 61a.

In the present embodiment, the sub-slider 80 has a return unit 81. The return unit 81 returns the valve body 63 from position of the surface where the openings 61a to 61d are formed to the original position when the pressing achieved with the cam of the pressing unit 71 is released. The return unit 81 is configured as a unit having, e.g., a spring 82 and a spring pressing portion 84, for reciprocally moving the valve body 63 in a direction that allows the valve body 63 to directly face the surface where the openings 61a to 61d are formed. The spring 82 is contracted when the valve body 63 is pressed toward the openings 61a to 61d. When the pressing is released, the spring 82 is extended and, hence, the valve body 63 is returned so as to be away from the openings 61a to 61d. The spring 82 may be substituted with any component as long as it is extensible/contractible likewise.

When the main slider 70 slides, i.e., moves upward in the present embodiment, the roller 68 starts to roll along the inclined portion 73 from the vertex of the protrusion 72 contrary to the case of blocking the openings. At the same time, the springs 82 is extended, and the valve body 63 returns to the original position from the openings 61a to 61d. At this time, the roller 69 rolls on the horizontal top surface of the valve body stopper 90 and retreats the valve body 63 from the openings 61a to 61d. Then, when the sub-slider 80 is hooked to the hook portion 74 of the main slider 70, the main slider 70 raises the sub-slider 80 and the valve body 63 in a direction parallel to the openings 61a to 61d. The main slider 70 raises the sub-slider 80 and the valve body 63 until the slit-shaped openings 65a to 65c directly face the openings 61b to 61d and the valve body 63 is misaligned with the opening 61a. Accordingly, the openings 61a to 61d are opened by the slit-shaped openings 65a to 65c and the valve body 63 (Fig. 6A).

Hereinafter, specific examples of the main slider 70 and the sub-slider 80 will be described.

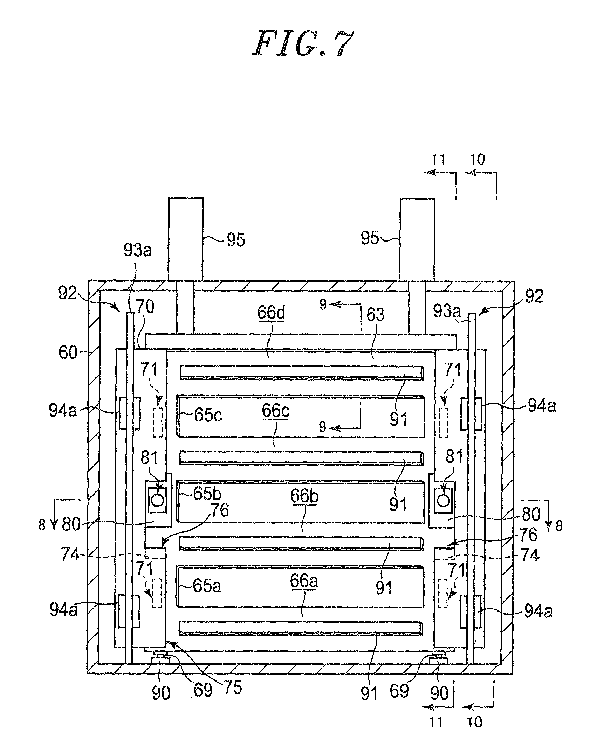

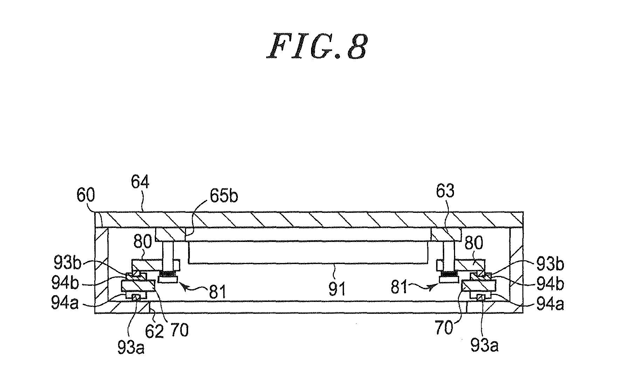

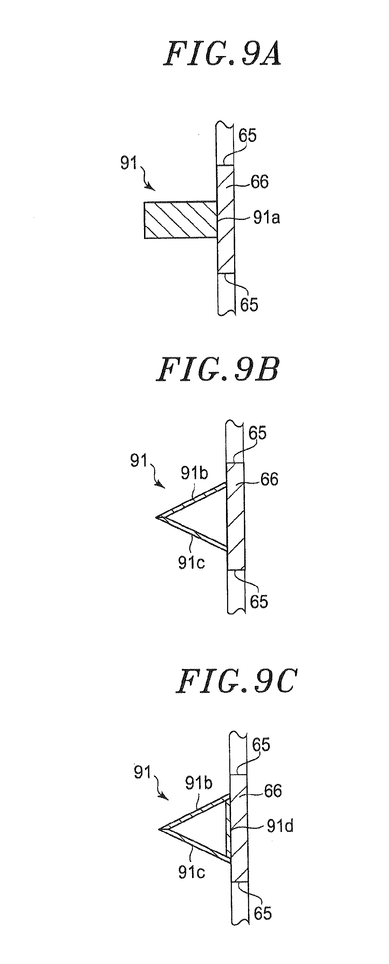

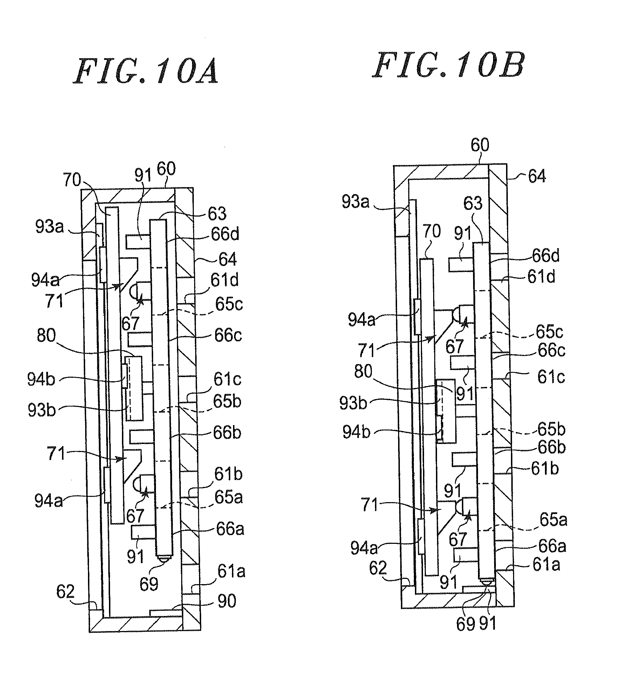

Fig. 7 is a partial front cross sectional view showing a specific example of the gate valve in accordance with the embodiment of the present invention. Fig. 8 is a horizontal cross sectional view taken along line 8-8 in Fig. 7. Figs. 9A to 9C are cross sectional views taken along line 9-9 in Fig. 7. Figs. 10A to 10B are cross sectional views taken along line 10-10 in Fig. 7.

As shown in Figs. 7 and 8, the main slider 70 has a cutoff portion 75 having a lower open end through which a substrate G passes to form a frame shape having a lower open end. The slit-shaped openings 65a to 65c of the valve body 63 are exposed through the cutoff portion 75. The substrates G that have passed through the cutoff portion 75 can be loaded and unloaded through the openings 61a to 61d formed in front of the main slider 70. Since the lower end of the cutoff portion 75 is opened as described above, when the main slider 70 is raised, it does not disturb the loading or unloading of the substrates G.

In the present embodiment, one or more sub-sliders 80 are provided between both outer sides of the cutoff portion 75 of the main slider 70 through which the substrate G passes and both side portions of the valve body 63. The gap between the sub-sliders 80 provided at both side portions is set to be greater than the horizontal size of the substrates G passing through the slit-shaped openings 65a to 65c. Hence, the loading and unloading of the substrates G is not disturbed by the sub-sliders 80. In order to ensure stable operation of the valve body, it is preferable to provide the same number of the sub-sliders 80 at both sides symmetrically. The number of the sub-sliders 80 may be two or more depending on the size of the valve body. When stable operation of the valve body can be ensured, it is not essential to provide the same number of the sub-sliders 80 at symmetrical locations.

Ribs 91 are provided at a surface of the blocking portions 66a to 66d which is opposite to the surface where the openings 61a to 61d are formed. When the main slider 70 is provided with the cutoff portion 75 through which the substrate G passes as in the present embodiment, the blocking portions 66a to 66d are exposed through the cutoff portion 75. In other words, the blocking portions 66a to 66d cannot be pressed by the pressing unit 71. Therefore, when the blocking portions 66a to 66d are subjected to a back pressure generated by the processing chambers 10a and 10b or the load-lock chamber 20 through the openings 61a to 61d, the blocking portions 66a to 66d are bent and this may results in deterioration of airtightness.

In order to suppress the deterioration of airtightness, the ribs 91 may be provided at the blocking portions 66a to 66d as in the present embodiment. The main slider 70 is provided at the sides of the blocking portions 66a to 66d, and the pressed portions 67 of the valve body 63 are pressed by the pressing units 71. Thus, the bending of the blocking portions 66a to 66d is prevented by the ribs 91, thereby suppressing the deterioration of airtightness.

The rib 91 may be a rectangular rod-shaped member of which cross section has a major axis and a minor axis, or may be a truss-shaped member having a triangular cross section.

In case of the rod-shaped member, it is preferable to have a surface 91a of a minor axis side to be fixed to the blocking portion 66 of the valve body 63 as shown in Fig. 9A. This is because the ribs 91 of the valve body are not easily bent and the deformation of the blocking portion 66 can be further suppressed compared to when a surface of a major axis side is connected to the blocking portion 66.

The truss-shaped member may be configured by joining an end of a plate 91b with that of a plate 91c and fixing the other open ends thereof to the blocking portion 66 as shown in Fig. 9B, or may also be configured by forming a triangle with three plates 91b to 91d and fixing one side of the triangle to the blocking portion 66 as shown in Fig. 9C. In that case as well, the ribs 91 are hardly bent, so that the deformation of the blocking portions 66a to 66d can be suppressed. The truss-shaped member has a hollow inner space unlike the rod-shaped member, so that the weight of the ribs 91 and the valve body 63 can be reduced.

As for a unit for sliding the main slider 70, there may be suggested a unit for moving the main slider 70 in a linear motion. An example of the linear moving unit includes an LM (linear motion) guide. In the present embodiment, an LM guide 92 is used as a unit for sliding the main slider 70. Figs. 10A and 10B are vertical cross sectional views taken along line 10-10 in Fig. 7.

As shown in Figs. 7, 8 , 10A and 10B, the LM guide 92 has a guide rail and guide blocks. In the present embodiment, two guide rails 93a are disposed at portions outward of the openings 62 of the gate valve chamber 60 so that loading and unloading of substrates G are not disturbed. The guide rails 93a of the present embodiment are attached to the inner wall of the gate valve chamber 60. Further, the guide rails 93a may be separated from the inner wall of the gate valve chamber 60. Guide blocks 94a are provided at a surface of the main slider 70 which corresponds to the guide rails 93a. The guide blocks 94a are fitted to the guide rail 93a so as to be slidable. Accordingly, the main slider 70 slides, i.e., vertically moves in the present invention, along the guide rail 93a while holding the guide rail 93a (see Figs. 10A and 10B).

In addition, a guide rail 93b is provided at a surface of the sub-slider 80 which corresponds to the main slider 70, and a guide block 94b is provided at a surface of the main slider 70 which corresponds to the sub-slider 80. The guide block 94b is fitted to the guide rail 93b so as to be slidable. Hence, the main slider 70 holds the guide rail 93b of the sub-slider 80. The sub-slider 90 slides, i.e., vertically moves in the present embodiment, along the guide block 94b of the main slider 70 (see Figs. 10A and 10B).

A driving unit 95 for sliding the main slider 70 is provided above the main slider 70. In the present embodiment, two driving units 95 are positioned above both side portions of the main slider 70. The driving unit 95 may be, e.g., an air cylinder, a hydraulic cylinder or the like.

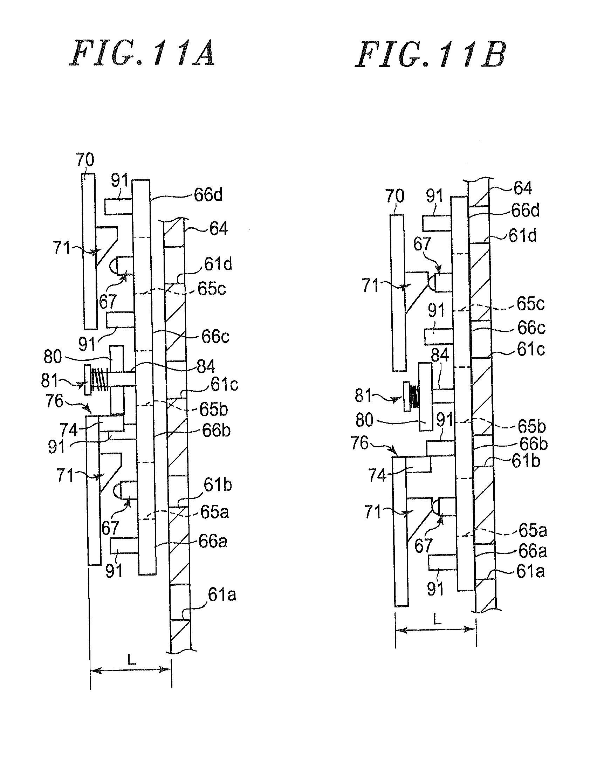

Figs. 11A and 11B are vertical cross sectional views taken along line 11-11 in Fig. 7.

As shown in Figs. 11A and 11B, the main slider 70 of the present embodiment is provided with an interference preventing cutoff portion 76 for preventing an interference with the return unit 81. The cutoff portion 76 is formed at the main slider 70 to accommodate a leading end portion of the return unit 81 of the sub-slider 80. By accommodating the leading end portion of the return unit 81 in the cutoff portion 76, a length L from the main slider 70 to the sidewall surfaces of the openings 61a to 61d of the gate valve chamber 60 or to the opening plate 64 can be reduced compared to when the main slider 70 is not provided with the cutoff portion 76 as shown in Figs. 6A to 6C, for example. Therefore, the length of the gate valve chamber 60 along the transfer direction of the substrate G (the thickness of the gate valve chamber 60) can be reduced, so that the transfer distance of the substrate G between the common transfer chamber 30 and the processing chamber 10a or 10b or the load-lock chamber 20 can be decreased, or an increase in the transfer distance of the substrate G between the common transfer chamber 30 and the processing chamber 10a or 10b or the load-lock chamber 20 can be suppressed. By decreasing or suppressing the increase of the substrate G transfer distance, it is possible to prevent, e.g., a transfer arm of the transfer unit 40, from being lengthened.

In accordance with the above embodiment, it is possible to obtain a gate valve that can reduce an elevation distance of a valve body even when the number of objects to be processed simultaneously is increased, and a substrate processing system using the gate valve.

The present invention is not limited to the above-described embodiment and can be variously modified. Further, the embodiment of the present invention is not limited to the above-described embodiment.

For example, four or six openings 61 are illustrated in the above-described embodiment. However, the number of the openings 61 is not limited thereto, and may be greater than or equal to two.

In the above embodiment, the gate valve chamber 60 has been described as an example of an accommodating body for accommodating a gate valve. However, the accommodating body may also be a valve box for accommodating a gate valve.

In the above embodiment, the glass substrate used for fabrication of an FPD or a solar cell has been described as an example of an object to be processed. However, the object to be processed is not limited to the glass substrate, and may also be another substrate such as a semiconductor wafer or the like.

While the invention has been shown and described with respect to the embodiments, it will be understood by those skilled in the art that various changes and modification may be made without departing from the scope of the invention as defined in the following claims.

## Claims

1. A gate valve comprising:
a plurality of openings through which objects to be processed are loaded and unloaded;
a valve body to be pressed toward the openings;
a pressed portion provided to the valve body;
a main slider slidable in parallel with a surface where the openings are formed; and
a cam, provided to the main slider and having a protrusion and an inclined portion inclined from the protrusion in a sloped shape, for pressing the pressed portion of the valve body in a state where the valve body faces the openings,
wherein the valve body has one or more slit-shaped openings serving as opening portions for opening the openings, and portions adjacent to the slit-shaped openings serving as blocking portions for blocking the openings.

2. The gate valve of claim 1, wherein when the openings need to be blocked, the blocking portions of the valve body are moved to locations facing the openings and the valve body is pressed toward the surface where the openings are formed by the cam; and
wherein when the openings need to be opened, the pressing achieved with the cam is released and the slit-shaped openings of the valve body are moved to locations facing the openings.

3. The gate valve of claim 2, further comprising: a sub-slider provided between the valve body and the main slider, the sub-slider being slidable in parallel with the surface where the openings are formed,
wherein the sub-slider has a return unit for holding the valve body and returning the valve body to the original position from the surface where the openings are formed when the pressing achieved with the cam is released.

4. The gate valve of claim 3, wherein the main slider has a hook portion to which the sub-slider is hooked; and
wherein the pressing achieved with the cam is released by sliding the main slider in parallel with the surface where the openings are formed, and the openings are opened by the slit-shaped openings by sliding the sub-slider hooked to the hook portion together with the valve body in parallel with the openings.

5. The gate valve of claim 4, further comprising a valve body stopper for stopping the sliding of the valve body, wherein when the main slider slides further after the sliding of the valve body is stopped by the stopper, the hook that has been achieved between the main slider and the sub-slider by the hook portion is released, and the cam presses the valve body toward the surface where the openings are formed.

6. The gate valve of claim 5, wherein a roller for moving the valve body back and forth in a direction facing the surface where the openings are formed is provided between the valve body stopper and the valve body.

7. The gate valve of any one of claims 1 to 5, wherein a rib is formed at a surface of the blocking portion of the valve body which is opposite to the surface where the openings are formed.

8. The gate valve of claim 7, wherein the rib is a rectangular rod-shaped member of which cross section has a major axis and a minor axis, and a surface of the rod-shaped member along the minor axis is fixed to the blocking portion of the valve body.

9. The gate valve of claim 7, wherein the rib is a truss-shaped member having a triangular cross section, and one side of the truss-shaped member serves as the blocking portion of the valve body or is fixed to the blocking portion of the valve body.

10. The gate valve of any one of claims 7 to 9, wherein the pressed portion of the valve body is disposed along both sides of the openings at the opposite surface of the surface where the openings are formed.

11. The gate valve of any one of claims 1 to 10, wherein the main slider has a cutoff portion through which the object passes.

12. The gate valve of claim 11, further comprising one or more sub-sliders provided between the valve body and the main slider, said one or more sub-sliders being slidable in parallel with the surface where the openings are formed,
wherein said one or more sub-sliders are provided between both outer sides of the cutoff portion of the main slider and both sides of the valve body.

13. The gate valve of claim 12, wherein the main slider has an interference preventing cutoff portion for accommodating a leading end portion of the return unit of the sub-slider.

14. A substrate processing system comprising:
a processing chamber having an opening through which an object to be processed is loaded and unloaded, the processing chamber serving to accommodate the object in a vacuum state and process the object;
a load-lock chamber having an opening through which the object is loaded and unloaded, the load-lock chamber serving to accommodate the object in an atmospheric state as well as in a vacuum state and exchange an unprocessed object with a processed object; and
a transfer chamber having an opening through which the object is loaded and unloaded, the transfer chamber serving to accommodate the object in a vacuum state and transfer the object between the load-lock chamber and the processing chamber,
wherein the gate valve described in any one of claims 1 to 13 is used as a gate valve for opening and closing the opening of at least one of the processing chamber, the load-lock chamber and the transfer chamber, through which the object is loaded and unloaded.
